Europäisches Patentamt

(19) European Patent Office

Office européen des brevets

(11) Publication number : **0 288 711 B1**

(12) **EUROPEAN PATENT SPECIFICATION**

(45) Date of publication of patent specification :
22.02.95 Bulletin 95/08

(51) Int. Cl.⁶ : **H01L 39/24**, H01L 39/12, C23C 4/10

(21) Application number : 88104095.0

(22) Date of filing : 15.03.88

(54) **Rapid, large area coating of high-Tc superconductors.**

(30) Priority : 28.04.87 US 43523

(43) Date of publication of application :
02.11.88 Bulletin 88/44

(45) Publication of the grant of the patent :
22.02.95 Bulletin 95/08

(84) Designated Contracting States :
DE FR GB

(56) References cited :
EP-A- 0 286 135
EP-A- 0 302 506
EP-A- 0 323 582
EP-A- 0 324 121
EP-A- 0 330 196
DE-A- 2 155 217
JOURNAL OF THE CANADIAN CERAMIC
SOCIETY, vol. 54, 1985, pages 14-20; G.J.MUR-
PHY et al.: "Ceramic electrocatalysts for the
oxygen evolution reaction. II:Plasma sprayed
Perovskite coatings"
EXTENDED ABSTRACTS OF THE SPRING
MEETING OF THE MRS, HIGH TEM-
PERATURESUPERCONDUCTORS, Anaheim,
23rd-24th April 1987, pages 81-84, MRS,
Pittsburgh,US; R.H. KOCH et al.: "Thin films
and squids made from YBa2Cu3Oy"
ADVANCED CERAMIC MATERIALS, vol. 2, no.
3B, 20th July 1987, pages 422-429,ACerS; J.J.
CUOMO et al.: "Large area plasma spray
deposited superconducting YBa2Cu3O7 thick
films"

(56) References cited :
ADVANCED CERAMIC MATERIALS- CERAMIC
SUPERCONDUCTORS, vol. 2, no. 3B, July
1987,pages 401-410, Westerville, OH, US; J.P.
KIRKLAND et al.: "Thermal spraying super-
conducting oxide coatings"
PATENT ABSTRACTS OF JAPAN, vol. 13, no.
84 (C-572)[3432], 27th February 1989; & JP-
A-63 270 450
Physical Review Letters, Vol. 58, No. 9, 2
March 1987, pp. 908-910

(73) Proprietor : **International Business Machines
Corporation**
**Old Orchard Road**
**Armonk, N.Y. 10504 (US)**

(72) Inventor : **Cuomo, Jerome John**
**Lovell Street**
**Box 353**
**Lincolndale, N.Y. 10540 (US)**
Inventor : **Guarnieri, C. Richard**
**Annarock Drive**
**Somers New York 10589 (US)**
Inventor : **Rosenberg, Robert**
**101 Lakeview Avenue**
**W., Peekskill, N.Y. 10566 (US)**
Inventor : **Sek-On Yee, Dennis**
**RR3, Box 519**
**Kenneth Drive**
**Putnam Valley, N.Y. 10579 (US)**
Inventor : **Walker, George Frederick**
**1540 York Avenue**
**New York, N.Y. 10028 (US)**

(74) Representative : **Barth, Carl Otto**
**International Business Machines Corp.**
**Zurich Research Laboratory**
**Intellectual Property Department**
**Säumerstrasse 4**
**CH-8803 Rüschlikon (CH)**

## Description

The invention relates to a method for coating any type of substrate with a high-$T_c$ superconductor, and more particularly to a thermal spray method of coating these superconducting materials in a manner to provide large area coatings which have superior superconductive properties.

Superconductivity is usually defined as the complete loss of electrical resistance of a material at a well defined temperature. It is known to occur in many materials, including about a quarter of the elements of the periodic table and over 1000 alloys and other multi-component systems. Generally, superconductivity is considered to be a property of the metallic state of the material since all known superconductors are metallic under the conditions which cause them to be superconducting.

Superconductors are known to be very attractive for many applications, and in particular high speed switching devices, such as Josephson-type switches, high density packaging and circuit layouts, electrical instrumentation, magnetic shields, power transmission lines, and so on. While the advantages of superconductors are quite obvious to scientists and engineers, the common disadvantage of superconductive materials had been their very low transition temperature. This temperature is often called the critical temperature $T_c$, and is the temperature above which superconductivity will not exist. For many years, the composition having the highest known $T_c$ was $Nb_3Ge$ which exhibits a $T_c$ of about 23 K. A review of these materials is contained in M.R. Beasley et al., Phys. Today, Vol. 37 (10), 60 (1984).

In 1986, a significant technical breakthrough was reported by J.G. Bednorz and K.A. Müller in Z. Phys. B - Condensed Matter, Vol. 64, page 189 (1986). This breakthrough was the first major improvement in the superconducting transition temperature in the last decade, the materials described by Bednorz and Müller being transition metal oxides which could include rare earth or near rare earth elements, as well as alkaline earth substitutions. These materials exhibited layer-like crystalline structures often characterized by oxygen deficiencies or excesses. The transition metal is believed to be multi-valent while many choices are available for the rare earth, near rare earth, and alkaline earth elements. Examples of such high-$T_c$ superconductors include oxides in the La-Sr-Cu-O and Y-Ba-Cu-O systems. In particular, a very good superconducting material is one exhibiting the so-called 1-2-3 phase given by the formula $YBa_2Cu_3O_y$, where y has a value necessary to satisfy the valence requirements of the composition. Another publication further describing these materials is J.G. Bednorz et al., Euro-Physics Letters, Vol. 3 (3), page 379 (1987). The class of materials first described by Bednorz and Müller and exemplified hereinabove will hereinafter be referred to as high-$T_c$ superconductors. This is the term generally used by those working in this field to describe these materials, the materials being characterized as transition metal oxides having superconducting transition temperatures greater than about 30 K.

Since the pioneering work of Müller and Bednorz, there has been considerable technical activity to further develop these superconductors and to provide compositions having even higher critical transition temperatures. References describing these high-$T_c$ superconductors, and particularly the La-Sr-Cu-O and Y-Ba-Cu-O systems, are the following:

Cava et al, Phys. Rev. Letters, Vol. 58, 408 (1987);
Chu et al, Phys, Rev. Letters, Vol. 58, 405 (1987).

Another significant advance in the field of high-$T_c$ superconductors was the first report of the successful fabrication of films of high-$T_c$ compositions and specifically films belonging to the La-Sr-Cu-O and Y-Ba-Cu-O systems. These films were described by R. Laibowitz et al. on March 18, 1987 at the meeting of the American Physical Society in New York City. The general teaching of Laibowitz et al. is a vapor deposition technique in which multiple metal sources are used to provide vapor transport of metal atoms to a substrate which is in an oxygen ambient. For example, electron beam heated sources are filled with the desired metals, e.g., La, Sr, and Cu, or Y, Ba, and Cu. The rates of evaporation are adjusted to give the nominal desired composition at the substrate. Subesequent annealing in an oxygen atmosphere at about 900°C is used to provide the desired stoichiometry in the deposited film.

Although the interest in these high-$T_c$ superconductors is significant, so far there has been no way to provide coating techniques whereby large areas and irregular shapes (such as wires and ribbons) can be rapidly coated with films of these materials. Further, the provision of thick films in large area coatings has not been taught or suggested in the art. For many applications, such as large area magnetic shields, it would be advantageous to have a technique that would provide good quality high-$T_c$ superconductive coatings over large areas. This in turn would eliminate the need for large costly vacuum deposition sources and the complexity of such systems.

Accordingly, it is an object of this invention to provide a technique for rapid, large area coating of high-$T_c$ superconductors on substrates.

It is another object of the present invention to provide techniques for coating substrates having arbitrary geometries and shapes.

It is another object of the present invention to provide a method for forming thick films of high-$T_c$ superconductors on arbitrarily chosen substrates, where the quality of the coated film is superior to the quality of the starting materials in the process.

It is another object of the present invention to provide a process allowing very large throughput when high-$T_c$ superconductors are coated as thick films on large area substrates.

This invention is a thermal spray deposition technique for depositing coatings of high-$T_c$ superconducting material over large areas and onto substrates having varying geometries, and more particularly to a plasma spray deposition process for depositing coatings of these high-$T_c$ superconductors having superior properties. In this process, the high-$T_c$ superconductor is prepared in bulk form and crushed to a powder generally having a particle size between about 1 μm and 60 μm. The powder is then carried by a gas and injected into a hot plasma gas stream where it is heated and carried to the substrate to be coated.

The substrate is heated to a temperature of 200 - 700°C. The coating thickness is generally from about 2 μm to about 250 μm.

The material deposited on the substrate may not have ideal superconducting characteristics (i.e., high-$T_c$) and can in some cases be non-superconducting. In the practice of this invention, the deposited coating is annealed, usually in an oxygen environment, to restore or produce high-$T_c$ superconducting behavior. It has been discovered that coatings produced in this way can have superior superconducting properties in contrast with the starting material that is crushed to make the powder. Generally, the annealed coating has a higher percentage of the desired superconducting phase in it than does the starting material from which the powder is formed for use in the coating process. Surprisingly, this result occurs even if the as-deposited coating does not have the desired structures.

Generally, the high-$T_c$ superconducting material to be deposited is prepared in particle form and entered into an apparatus where the particles are heated by a plasma or an arc. The heated particles are then transported at high speeds to the substrate where they condense with adhesion on the substrate to provide the substrate coating. The coating is then annealed to homogenize it and to more completely form the superconducting phase.

These and other objects, features, and advantages will be apparent from the following more particular description of the preferred embodiments given in connection with the drawings in which:

FIG. 1 is a schematic illustration of the plasma spray deposition process of the present invention, in which powders containing the constituents of the desired high-$T_c$ superconductor are heated by a plasma and carried to a substrate on which they form a coating.

FIG. 2 is a schematic illustration of a modification of the apparatus of FIG. 1, showing the entry of the powder into the plasma at a location beyond the exit throat of the plasma gun, as well as the provision of ports for introducing an additional gas into the plasma stream.

FIG. 3 is a plot of resistance versus temperature for an annealed coating deposited on a substrate using the process of this invention, the deposited coating being $YBa_2Cu_3O_y$, and the substrate being $Al_2O_3$.

FIG. 4 is another plot of resistance versus temperature for an annealed coating deposited on a substrate using the process of this invention, the deposited coating being $YBa_2Cu_3O_y$ on Cu.

This invention uses the general principles of thermal spray deposition, and in particular plasma deposition, together with post-deposition annealing to achieve superior high-$T_c$ superconductors over large areas, and in particular plasma deposition. Generally, plasma and detonation gun coatings have been used in industry for many years, and are described in the following references:

R.F. Bunshah et al., Deposition Technologies for Films and Coatings, published by Noyes Publications, Parkridge, New Jersey, 1982, see pp. 454-488.

From the Journal of the Canadian Ceramic Society, Vol. 54, 1985, pp. 14-20, a plasma spraying deposition is known for coating a substrate with a layer of ceramic material having a perovskite structure.

In the European patent application EP-A-0286135, falling under Art. 54(3) EPC, a method for producing a ceramic superconducting compound by flame or plasma spraying the elements of the compound onto a substrate is described.

Both plasma and d-gun processes are line-of-sight processes in which powder is heated to near or above its melting point and accelerated (by either a detonation wave or a plasma gas stream) to a substrate. The powder is directed to the substrate to be coated and on impact forms a coating consisting of many layers of overlapping thin lenticular particles or splats. In this process, the coating thicknesses can range from about 1 μm to above 250 μm.

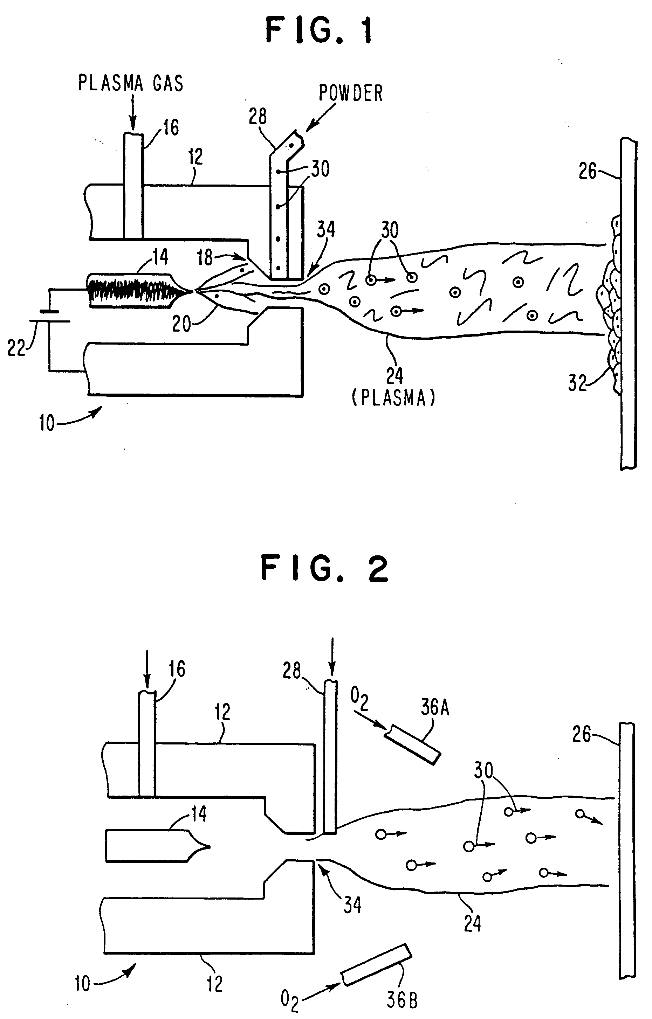

Referring more particularly now to FIG. 1, a plasma spray deposition apparatus is shown using a plasma torch 10 that includes an anode 12 and a cathode 14. The anode 12 is usually copper while the cathode 14 is usually comprised of tungsten. A gas that is used for the plasma and for transport of particles to the substrate is introduced into the torch via the inlet tube 16. The gas is usually argon or nitrogen or a mixture of these with hydrogen or helium. In the examples to be described hereinafter, different gas combinations were used, including Ar + He, Ar + H, and Ar alone. The plasma gas flows around the cathode 14 and through the anode which serves as a constricting nozzle 18. A direct current arc 20, usually initiated with a high frequency discharge is produced when power is supplied between the anode 12 and the cathode 14, as represented by the voltage source 22. The arc current and voltage used vary with the anode/cathode design, gas flow, and gas composition, as is well known in the art. The power used varies from about 5 to 80kW depending upon the type of of torch and the operating parameters. Specific examples using powers in the range of about 20-50kW will be described.

The arc causes a plasma 24 to be produced. The gas plasma generated by the arc consists of free electrons, ionized atoms, and some neutral atoms and undissociated diatomic molecules, if nitrogen or hydrogen is used. The specific anode/cathode configuration, gas density, mass flow rate and current/voltage determine the plasma temperature and velocity. Plasma gas velocities with most conventional torches are subsonic, the temperature of the plasma being variable and sometimes in excess of 50,000 K. In the examples to be given later, the plasma temperature is about 5000 K.

In order to deposit a coating on the substrate 26, powders of the material to be deposited enter torch 10 through inlet tube 28. The powder particles 30 are carried by a carrier gas, such as Ar, and enter the plasma near the torch opening in the design of FIG. 1. The powder particles are then carried to the substrate 26 where they produce the coating 32.

The velocity that the powder particles 30 achieve in the plasma stream 24 depends primarily on the plasma gas flow rate and secondarily on the integrated effect of mass flow rate of the plasma and the distance the powder is carried in the stream. Similarly, the temperature the powder achieves is a function of the integrated effect of the plasma temperature, (more specifically enthalpy) plasma composition and the transit time in the plasma stream. In turn, the powder velocity and temperature are functions of factors such as the particle size, powder composition, heat capacity, density, emissivity, etc. For many applications the point of entry of the powder into the plasma stream is important and the ideal location is in a uniform pattern upstream of the anode throat 34 since this would probably allow the best distribution of the powder in the plasma stream, expose the powder to the highest plasma temperature, and provide the longest path or time in transit. However, due to the problems of powder adherence to the entry or throat of the nozzle and excessive superheating, the powder entry is usually in the diverging portion of the nozzle or just beyond the torch exit (FIG. 2).

As noted, the particles can be molten or partially molten upon impact on the substrate 26. The combination of particle plasticity or fluidity and velocity is such that the particle is allowed to flow into a thin lenticular shape that molds itself to the topology of the substrate or to previously deposited material. The extent to which this will be achieved will determine the strength and density of the coating 32.

The powder is not heated to an excessive temperature by the plasma due to the short transit time in the plasma. The extent of reaction of the powder with the gaseous environment of the plasma during transit depends upon the composition of the plasma gas and the amount of intermixing of the plasma gas with the ambient gas between the nozzle throat 34 and the substrate 26. When inert gases, such as argon and helium, are used, substantially no degradation of the powder occurs.

The plasma torch 10, plasma gas controls, power supplies, and feeders to provide the powder 30 in the torch 10 are all commercially available. For optimum plasma spraying, the powder must be distributed uniformly in the plasma stream at a constant rate. There are a variety of powder dispensers designed to do this which are commercially available. In order to have a uniform coating on the substrate 26, the substrate can be rotated or laterally transported manually or fully automated. Generally, since plasma deposition is a line-of-sight process, the structure of the coating is a function of the angle of deposition, i.e., the angle between the axis of the plasma jet effluent and the surface of the substrate 26. Coatings having the highest density and bond strength are typically achieved at a 90° angle of deposition. However, there is some leeway in the angle of deposition and, if the torch velocity is sufficiently high, angles as low as about 60° can be tolerated.

The size of the torch 10 which can be used in the present invention can be changed readily and still provide a satisfactory coating 32. Typical stand-off distances, i.e., the distance from the nozzle or front face of the torch to the substrate 26, can vary from about 2,5 cm to approximately 7,5 cm or more.

The size of the particles 30 in the powder is generally between about 1 and 60 $\mu$m in size. In order to achieve uniform heating and acceleration, it is advisable to have as narrow a size distribution as possible. The heating characteristics of the powder often influence the size of the powder particles that are used. Generally, fine powder particles are accelerated and heated more rapidly in the plasma stream 24, but they also tend to lose momentum more rapidly when spraying at longer distances. The use of fine powders generally results in denser but more highly stressed coatings. In the examples to be described more fully later, Y-Ba-Cu-O coatings of good quality were fabricated using particle sizes which would pass through a 325 mesh (about 0.5 $\mu$m to 40 $\mu$m) narrowing this distribution and using small size particles will improve the coating produced.

Although it is not shown in FIG. 1, a mask can be used to limit the deposition to a selected area of the substrate 26. The type of masking material that is used will depend on the plasma and particle velocity and on the stand-off distance, as is well known in the art. For high velocity, short stand-off distances, more durable masks will be required.

The substrate can be cooled during deposition to avoid any possibility of distortion or volumetric change of the substrate. However, in our work, the substrate was usually heated prior to plasma spraying in order to remove any adsorbed gases from the substrate surface prior to coating and was also heated during deposition. For the deposition of high-$T_c$ superconductors, the substrate was held at an elevated temperature, for example, 200-700°C.

FIG. 2 is a variation of the plasma spray deposition apparatus of FIG. 1. For ease in comparing these drawings, the same reference numerals are used for components which function in a similar manner. One difference in structure with respect to FIG. 1 is that the inlet tube 28 for the powder and its carrier gas is now located just outside the exit opening 34 of the torch 10, rather than being in a portion of the anode 12. Another difference is that additional gas input ports 36A and 36B are located adjacent to the plasma stream 24 for providing additional gases, such as oxygen. This additional oxygen can be used to supply oxygen to compensate for any oxygen that is lost while the particles 30 are in transit to the substrate 26. By providing the gas into the plasma, the gas is made more reactive.

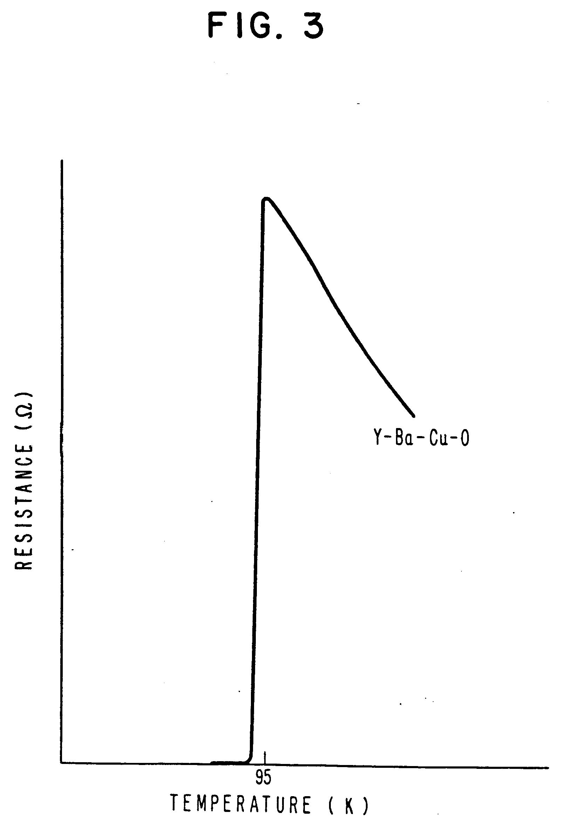

FIG. 3 is a plot of resistance versus temperature for a high-$T_c$ superconductor coating that has been deposited onto an aluminium oxide substrate by the present invention. This coating was subjected to a 2-step post-deposition annealing involving heating for 12 hours at 932°C in an oxygen environment, cooling the coating for 3 hours to a temperature of 473°C, and then heating the coating at 473°C for an additional 8 hours. The onset temperature for superconductivity was 95 K, while complete superconductivity was obtained at 72.7 K. This coating had the nominal composition $YBa_2Cu_3O_y$, where y is sufficient to satisfy the valence requirements of the composition. Typically, y is about 7. The substrate was aluminium oxide.

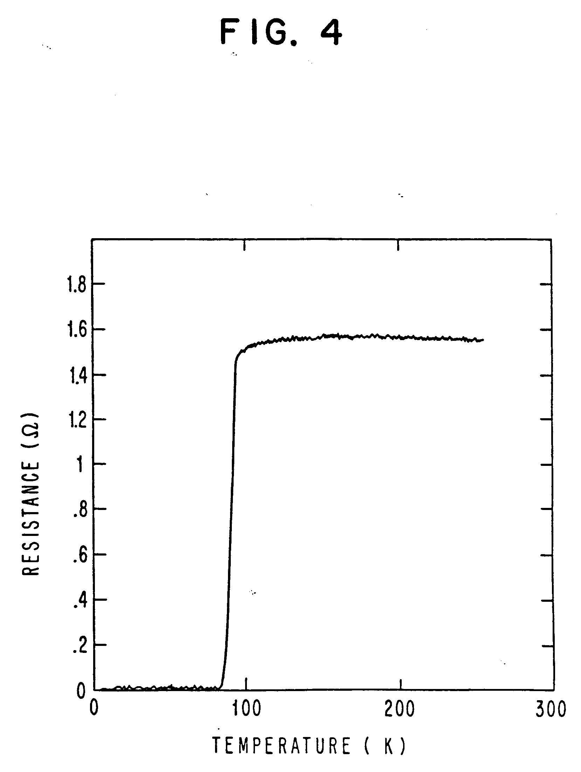

FIG. 4 is a plot of another $YBa_2Cu_3O_y$ coating on a Cu substrate - this coating was also annealed in an oxidizing atmosphere and exhibited a superconducting onset temperature of 101.4 K, and complete superconductivity at 8.24 K.

In order to make the coating depicted in FIG. 3, standard ceramic techniques were used to make a bulk ceramic of high-$T_c$ superconducting $YBa_2Cu_3O_y$. The bulk ceramic was made by combining copper oxide, yttrium oxide, and barium carbonate. These materials were then ground and put into an oven where they were heated to an elevated temperature (about 1600°C) for several hours. In order to obtain good superconducting properties, the resulting ceramic is annealed in an oxygen environment at temperatures of about 900°C. After this, the material is ground into small particles to create the powder that is used in the plasma spray technique. For typical coatings, a 325 mesh is used, meaning that the largest particles in the powder are those which will just pass through this 325 mesh sieve.

The gas used for the plasma and for transporting the particles is typically a mixture of Ar and He. By applying approximately 20-50kW, and introducing the powders in an Ar carrier gas, the particles will be put into a molten state and deposited on a substrate 26. Any substrate can be used including alumina, MgO, Cu, quartz, etc. The substrate can be heated to a temperature of 200-700°C, although such heating is not mandatory. After deposition, the films are subjected to an annealing cycle to perfect the high-$T_c$ superconducting phase.

The deposited coating is annealed in order to homogenize the coating and to produce the superconducting phase in the coating. It has been found that plasma coating followed by annealing produces coatings having a greater percentage of the superconducting phase than that present in the starting materials, even though the starting materials had been carefully refined and annealed. This rather surprising result may be due to the changes that occur to the particles during transit in the plasma, and to the annealing steps which appear to be important for proper atom arrangement in the lattice of the coated material.

The following is a discussion of the annealing steps and their effects on films of high-$T_c$ superconductors. For La and Sr coatings, a first anneal at about 400°C is used in a pure oxygen environment. This anneal is for approximately 6-30 minutes. It is then followed by a second annealing step at about 700°C in pure oxygen, again for about 6-30 minutes. The first low temperature anneal will add oxygen to the film, while the second higher temperature anneal is used to produce the proper phase for superconductivity. In these La-Sr-Cu-O films, if the annealing temperature is greater than about 550°C, the films will start to lose oxygen. However, an anneal at temperatures greater than this is often necessary to provide the proper perovskite-like phase for superconductivity. Therefore, the 2-step approach is used where the first annealing step at about 400°C enables additional oxygen to be incorported, while the second, higher temperature annealing step allows the formation of the proper phase, even though some oxygen will be lost.

For Y-Ba-Cu-O films, an intermediate annealing step is generally not required since these films contain enough oxygen. Therefore, Y-Ba-Cu-O films can generally be annealed directly at high temperature (about 900°C) in an oxygen atmosphere for a few minutes. They can then be slowly cooled (about 3 hours) to room temperature. In an alternative step, the Y-Ba films are first heated to about 900°C in a 100% He atmosphere. The presence of helium favors mixing in order to eliminate compositional uniformities which may be present in the film, making the film more homogeneous. This can be followed by an anneal in 100% oxygen for a few minutes at about 900°C.

As was noted previously, substrate heating can be used to provide good quality coatings. Substrate heating plasma composition and temperature transit distances, etc., is believed to control the ratio of the rare earth (or rare earth-like) element to the alkaline earth element, i.e., the ratio of metal atoms. Control of this ratio is important to obtain high-$T_c$ superconductors. These deposition conditions can also be used to control the degree of crystallinity and the crystalline phases in the as-deposited films. Since it is often difficult to control this ratio in the powder particles the proper phase and composition of metal atoms can be controlled by process conditions. Heating the substrate will also often allow the necessary reaction to occur at the substrate in order to obtain the proper ratio. In this manner, the substrate temperature can be used to smooth out variations in the composition which may be deposited on the substrate.

As was noted previously, the process of the present invention can be used to deposit any type of high-$T_c$ superconductor. In order to do so, a bulk ceramic of the superconductor is first made using well known ceramic techniques, after which the ceramic is crushed to create small particles. These are incorporated into the plasma, heated, and transported to the substrate where they are deposited. It is not necessary that an optimal starting ceramic be used prior to crushing to provide the powder. It appears that the initial ceramic can be an unreacted material, i.e., one not exhibiting a high transition temperature $T_c$. Proper control of the deposition conditions and subsequent annealing of the coating as described hereinabove will produce the high-quality superconductor.

The following tables will give representative examples of several Y-Ba-Cu-O coatings which were deposited on substrates using different deposition conditions. For these examples, the particle size was that which would pass through a 325 mesh, and approximately 100 g of the powder were used. The plasma sources were commercially available 3MB and 7MB sources. The substrate temperatures are indicated as is the plasma gun-substrate distance. The column headed "Shield Gas" refers to the provision of oxygen in the inlet ports 36A and 36B of FIG. 2. The sheet resistivity of the as-deposited film was measured for all examples. In TABLE 1, the plasma and transport gas is a mixture of Ar and He, while in TABLE 2 the plasma and transport gas for the same samples was a mixture of Ar and $H_2$, and for other samples was Ar.

Another suprising factor was that the degree of composition control was very good when the plasma gas was a mixture of He and Ar. However, the composition of the deposited films often changed (from that of the starting material) when the plasma gas was Ar and H. Thus, a layered structure having different properties can be made by changing the gas composition. Also, if the starting material is of high quality, He and Ar can be used, while, if the starting material is not of high quality, a plasma gas of Ar and H can be used to alter the composition.

## TABLE 1

| Run | Substrate | Shield Gas | Distance (cm) | Substrate Temp (°C) | V/l | kW | Sheet Resistivity ($\Omega$/sq.) |
|-----|-----------|-----------|---------------|---------------------|-----|-----|----------------------------------|
| 1 | $Al_2O_3$ | No | 6,25 | 600-700 | 57/500 | 28,5 | $0,2 \times 10^6$ |
| 3 | $Al_2O_3$ | No | 6,25 | 350-600 | 57/500 | 28,5 | $0,4 \times 10^6$ |
| 4 | $Al_2O_3$ | No | 6,25 | 200-350 | 57/500 | 28,5 | $1 \times 10^6$ |
| 5 | $Al_2O_3$ | No | 2,5 | 600-700 | 57/500 | 28,5 | $13 - 100 \times 10^3$ |
| 6 | $Al_2O_3$ | No | 2,5 | 200-350 | 57/500 | 28,5 | $1 - 3 \times 10^3$ |
| 8 | $Al_2O_3$ | No | 6,25 | 200-350 | 59/720 | 42,5 | $\infty$ |
| 9 | $Al_2O_3$ | No | 6,25 | 350-600 | 59/720 | 42,5 | $6 - 9 \times 10^5$ |
| 10 | $Al_2O_3$ | No | 6,25 | 600-700 | 59/720 | 42,5 | $9 - 10 \times 10^3$ |
| 11 | $Al_2O_3$ | No | 2,5 | 200-350 | 59/720 | 42,5 | $2 - 50 \times 10^3$ |
| 12 | $Al_2O_3$ | No | 2,5 | 600-700 | 59/720 | 42,5 | $29 - 103 \times 10^3$ |
| 15 | $Al_2O_3$ | $O_2$ | 2,5 | 600-700 | 57/500 | 28,5 | $12 - 45 \times 10^3$ |
| 16 | $Al_2O_3$ | $O_2$ | 6,25 | 600-700 | 59/720 | 42,5 | $3 - 10 \times 10^3$ |
| 17 | $Al_2O_3$ | $O_2$ | 2,5 | 600-700 | 59/720 | 42,5 | $1 - 14 \times 10^3$ |
| 18 | $Al_2O_3$ | $O_2$ | 6,25 | 350-600 | 49/1000 | 49 | $0,9 - 2 \times 10^6$ |
| 20 | Cu | No | 6,25 | 350-600 | 49/1000 | 49 | - |
| 22 | Quartz Tube | $O_2$ | 6,25 | 350-600 | 59/720 | 42,5 | - |

**TABLE 2**

| Run | Substrate | Plasma Gas | Distance (cm) | Substrate Temp (°C) | V/I | kW | Sheet Resistivity (Ω/sq.) |
|-----|-----------|------------|---------------|---------------------|-----|-----|---------------------------|
| 2 | $Al_2O_3$ | Ar + $H_2$ | 6,25 | 200-350 | 65/500 | 32,5 | $2 - 8 \times 10^5$ |
| 3 | $Al_2O_3$ | Ar + $H_2$ | 6,25 | 350-600 | 65/500 | 32,5 | $3 \times 10^5$ |
| 4 | $Al_2O_3$ | Ar + $H_2$ | 6,25 | 600-700 | 65/500 | 32,5 | $2 \times 10^4$ |
| 6 | $Al_2O_3$ | Ar + $H_2$ | 6,25 | 200-350 | 77/520 | 40 | $1,4 \times 10^6$ |
| 7 | $Al_2O_3$ | Ar + $H_2$ | 6,25 | 600-700 | 77/520 | 40 | - |
| 8 | $Al_2O_3$ | Ar + $H_2$ | 12,5 | 200-350 | 77/520 | 40 | $\infty$ |
| 9 | $Al_2O_3$ | Ar + $H_2$ | 12,5 | 600-700 | 77/520 | 40 | $2,6 - 4 \times 10^5$ |
| 11 | $Al_2O_3$ | Ar + $H_2$ | 6,25 | 350-600 | 55/500 | 27,5 | $1,2 \times 10^5$ |
| 14 | $Al_2O_3$ | Ar | 6,25 | 350-600 | 36/500 | 18 | $3,8 - 4,8 \times 10^5$ |
| 15 | $Al_2O_3$ | Ar | 6,25 | 600-700 | 36/500 | 18 | $1,5 - 4,5 \times 10^4$ |
| 16 | Cu, Steel | Ar | 6,25 | 200-350 | 36/500 | 18 | $\infty$ |
| 17 | Steel | Ar | 6,25 | 350-600 | 36/500 | 18 | - |

While examples have been given using powders of high-$T_c$ superconducting materials, it should be understood that the powders can be comprised of nonsuperconducting compounds of the materials to be incorporated in the final coating. For example, the powder can comprise copper oxide particles, yttrium or yttrium oxide particles, and barium oxides, carbonates, etc. The starting materials from which the powders are formed can therefore be oxides, sulfides, or other compounds. These powders can be fed into an oxygen-containing plasma whose oxygen content is adjusted along with substrate temperatures to preserve the stoichiometry desired in the coating. Additionally, the substrate can be in the shape of the final part to be used (for example, a wire or ribbon, and a through-hole in a plate) or the substrate can be one which can be further formed after the coating has been applied. The temperature of the plasma and/or substrate can be adjusted by the power applied to the plasma source 10 to either cause annealing and sintering during deposition (i.e., a higher temperature), or to facilitate post deposition annealing in a controlled furnace environment (i.e., a lower plasma temperature). In order to ensure uniformity of the coating, and to control substrate temperature the substrate can be rotated and manipulated during deposition. Equivalently, the substrate may be kept stationary while the source is moved (or any combination of those).

The plasma temperature can also be adjusted so that the particles can be kept either in the solid state or as liquid droplets during deposition. The temperature chosen will depend on the post-deposition annealing schedules and on the amount of microstructure control desired in the coating. Generally, more control of the coating structure will be provided as the particle size becomes more fine and as the temperature of the plasma increases. Particulates of the constituent oxides, sulfides, carbonates, or other compounds can be used as the powder feed material with subsequent sintering to a uniform composition taking place as the coating is being deposited on a hot substrate (heated to a temperature greater than about 400°C), or during the post-deposition anneal. By adjusting the velocity of impingement of the particles onto the substrate it is possible to produce elongated grains of materials in the coating in a direction parallel to the substrate surface. Such elongated grains could enhance the superconducting characteristics of the coating, as well as its mechanical properties. As noted, the deposition can be accomplished with non-oxidizing plasmas, also. For example, hydrogen can be used to reduce the coating. Generally, however, an oxygen-rich atmosphere appears to be preferrable. The composition of the film can be changed more easily with a hydrogen containing plasma, as noted above.

In a variation, the gas inlet tubes 36A and 36B in FIG. 2 can be used to provide a gas such as oxygen at a location close to the exit opening 34. This will cause the input oxygen molecules to travel a somewhat spiral path in the plasma 24, which in turn will create oxygen ions and atoms that are more reactive than oxygen molecules. This will lead to further incorporation of oxygen at the substrate.

It has been found that coatings that are formed on Cu have very good superconducting properties and a high transition temperature $T_c$, and provide a unique application of this invention. Such coatings on Cu may be used as magnetic shields, power transmission lines, etc.

The relative amounts of the various materials to be incorporated into the coating can be changed by changing the starting powder composition and by incorporating different gases into the plasma. Also, the annealing atmosphere (or plasma) can be an oxidizing atmosphere including not only oxygen, but gases such as $CO_2$, $NO_2$, etc. Further, while the present invention is particularly useful for the provision of coatings having a thickness of 10 $\mu$m and greater, it may be possible to produce thinner coatings.

Low pressure (i.e., below 1 bar) thermal spray processes may give more control of the cooling rate of the particles during their coolescence into the film which we have found to be important to the production of good high-$T_c$, superconducting properties.

## Claims

1. Plasma spray deposition method using a powder of a precursor material, introducing said powder into a plasma (**24**) generated in a plasma spraying apparatus (**10**), using said plasma (**24**) to heat and carry said powder to a substrate (**26**), letting said powder impinge and adhere at said substrate to form a layer (**32**), characterized in that a high-$T_c$ superconducting material is used as said precursor material, said substrate (**26**) is held during the deposition at a temperature between 200 and 700 °C, and said layer (**32**) is annealed in an oxidizing atmosphere at a temperature between 400 and 932 °C to produce a superconducting layer having a $T_c$ of greater than 30 K.

2. Method in accordance with claim 1, characterized in that the powder is introduced into the plasma (**24**) at a diverging part (**34**) of a front face or nozzle of the plasma spraying apparatus (**10**) or beyond said front face or nozzle.

3. Method in accordance with claim 1, characterized in that oxygen is introduced into the plasma (**24**).

4. Method in accordance with claim 3, characterized in that the oxygen is introduced into the plasma (**24**) between a front face or nozzle of the plasma spraying apparatus (**10**) and the substrate (**26**).

5. Method in accordance with claim 1, characterized in that hydrogen is introduced into the plasma (**24**).

6. Method in accordance with claim 1, characterized in that the layer (**32**) has a thickness ranging from 10 $\mu$m to 250 $\mu$m.

7. Method in accordance with claim 1, characterized in that the powder is heated to a molten state by the plasma (**24**).

8. Method in accordance with any of the preceding claims, characterized in that the distance between the substrate (**26**) and a front face or nozzle of the plasma spraying apparatus (**10**) is in the range of 2.5 cm to 7.5 cm.

9. Method in accordance with any of the preceding claims, characterized in that the pressure of the plasma (**24**) is maintained at less than $10^5$ Pa (1 bar).

## Patentansprüche

1. Plasmasprühdepositionsverfahren unter Verwendung eines Pulvers aus einem Vorprodukt-Material, wobei das Pulver in ein in einer Plasmasprühanlage (10) erzeugtes Plasma (24) eingebracht wird, wobei das Plasma (24) dazu verwendet wird, das Pulver aufzuheizen und es zu einem Substrat (26) zu transportieren, und wobei man das Pulver auf das Substrat auftreffen und an ihm haften läßt, um eine Schicht (32) zu bilden, dadurch gekennzeichnet ist, daß

ein hoch-$T_c$-supraleitendes Material als das Vorprodukt-Material verwendet wird, das Substrat (26) während der Deposition bei einer Temperatur zwischen 200 °C und 700 °C gehalten wird und die Schicht (32) in einer oxidierenden Atmosphäre bei einer Temperatur zwischen 400 °C und 932 °C gehalten wird, um eine supraleitende Schicht mit einem $T_c$ größer als 30 K zu erzeugen.

2. Verfahren nach Anspruch 1, dadurch gekennzeichnet, daß das Pulver in einem divergierenden Bereich (34) einer Vorderseite oder Düse der Plasmasprühanlage (10) oder jenseits der Vorderseite oder Düse in das Plasma (24) eingebracht wird.

3. Verfahren nach Anspruch 1, dadurch gekennzeichnet, daß Sauerstoff in das Plasma (24) eingebracht wird.

4. Verfahren nach Anspruch 3, dadurch gekennzeichnet, daß der Sauerstoff zwischen einer Vorderseite oder Düse der Plasmasprühanlage (10) und dem Substrat in das Plasma (24) eingebracht wird.

5. Verfahren nach Anspruch 1, dadurch gekennzeichnet, daß Wasserstoff in das Plasma (24) eingebracht wird.

6. Verfahren nach Anspruch 1, dadurch gekennzeichnet, daß die Schicht (32) eine Dicke im Bereich von 10 µm bis 250 µm aufweist.

7. Verfahren nach Anspruch 1, dadurch gekennzeichnet, daß das Pulver durch das Plasma (24) in einen schmelzflüssigen Zustand aufgeheizt wird.

8. Verfahren nach einem der vorhergehenden Ansprüche, dadurch gekennzeichnet, daß die Distanz zwischen dem Substrat (26) und einer Vorderseite oder Düse der Plasmasprühanlage (19) in dem Bereich zwischen 2,5 cm und 7,5 cm liegt.

9. Verfahren nach einem der vorhergehenden Ansprüche, dadurch gekennzeichnet, daß der Druck des Plasmas (24) auf weniger als $10^5$ Pa (1 bar) gehalten wird.

## Revendications

1. Procédé de dépôt par pulvérisation de plasma utilisant une poudre d'un matériau précurseur, consistant à introduire ladite poudre dans un plasma (24) généré dans un dispositif de pulvérisation de plasma (10), utiliser ledit plasma (24) pour chauffer et porter ladite poudre sur un substrat, laisser ladite poudre se déposer et adhérer audit substrat pour former une couche (32),
caractérisé en ce que
on utilise comme matériau précurseur un matériau supraconducteur à température critique élevée, ledit substrat (26) étant maintenu pendant le dépôt à une température entre 200 et 700 °C, et ladite couche (32) étant recuite dans une atmosphère oxydante à une température entre 400 et 932 °C pour produire une couche supraconductrice ayant une température critique supérieure à 30 °K.

2. Procédé selon la revendication 1, caractérisé en ce que la poudre est introduite dans le plasma (24) à une partie divergente (34) d'une face frontale ou tuyère du dispositif de pulvérisation de plasma (10) ou au delà de ladite face frontale ou tuyère.

3. Procédé selon la revendication 1, caractérisé en ce que de l'oxygène est introduit dans le plasma (24).

4. Procédé selon la revendication 3, caractérisé en ce que l'oxygène est introduit dans le plasma (24) entre une face frontale ou tuyère du dispositif de pulvérisation de plasma (10) et le substrat (26).

5. Procédé selon la revendication 1, caractérisé en ce que de l'hydrogène est introduit dans le plasma (24).

6. Procédé selon la revendication 1, caractérisé en ce que la couche (32) possède une épaisseur allant de 10 µm à 250 µm.

7. Procédé selon la revendication 1, caractérisé en ce que la poudre est chauffée à un état fondu par le plasma (24).

8. Procédé selon l'une quelconque des revendications précédentes, caractérisé en ce que la distance entre le substrat (26) et une face frontale ou tuyère du dispositif de pulvérisation de plasma (10) est dans une plage de 2,5 cm à 7,5 cm.

9. Procédé selon l'une quelconque des revendications précédentes, caractérisé en ce que la pression du plasma (24) est maintenue inférieure à $10^5$ Pa (1 bar).

# FIG. 1

PLASMA GAS

POWDER

24
(PLASMA)

# FIG. 2

$O_2$    36A

$O_2$    36B

# FIG. 3

# F I G. 4